# EUROPÄISCHE PATENTSCHRIFT

(11) **EP 0 850 140 B1**
(45) Veröffentlichungstag und Bekanntmachung des Hinweises auf die Patenterteilung: **25.07.2001**
(21) Anmeldenummer: 96934398.7
(22) Anmeldetag: 28.08.1996
(51) Int. Cl.: B44C 1/22, B44C 1/17, B05D 1/32

(54) **VERFAHREN ZUM SELEKTIVEN, BEREICHSWEISE BESCHICHTEN EINER TRANSPARENTEN TRÄGERPLATTE**
METHOD OF APPLYING A COATING SELECTIVELY TO PARTS OF A TRANSPARENT PLATE
PROCEDE DE REVETEMENT SELECTIF DE PARTIES D'UNE PLAQUE-SUPPORT TRANSPARENTE

(30) Priorität: 28.08.1995 DE 19531590
(43) Veröffentlichungstag der Anmeldung: 01.07.1998
(73) Patentinhaber: FRITZ BORSI KG, D-77602 Offenburg (DE)
(72) Erfinder: KALL, Klaus, D-77656 Offenburg (DE)
(74) Vertreter: Goddar, Heinz J., Dr.
(86) Internationale Anmeldenummer: DE9601611
(87) Internationale Veröffentlichungsnummer: WO9707992

(56) Entgegenhaltungen:
- EP-A- 0 536 852
- DE-C- 4 317 271
- GB-A- 2 158 368
- US-A- 5 436 027

## Beschreibung

Die Erfindung betrifft ein Verfahren zum selektiven, bereichsweise Beschichten einer transparenten Trägerplatte mit einer Wirkschicht, bei dem zunächst eine Abdeckfolie, die lediglich die nicht zu beschichtenden Bereiche der Trägerplatte abdeckt, auf der Trägerplatte ausgebildet wird, woraufhin die Wirkschicht auf die gesamte die Abdeckfolie tragende Fläche der Trägerplatte aufgebracht und schließlich die Abdeckfolie samt der darauf angeordneten Wirkschicht von der Trägerplatte abgezogen wird.

Ein solches Verfahren ist bspw. aus der DE-PS 38 08 689 bekannt, bei dem die Abdeckfolie in einem Siebdruckverfahren aufgebracht wird. Dieses Verfahren hat sich zwar durchaus bewährt, aber der Einsatz des Siebdruckverfahrens ist zum einen arbeits- und zum anderen kostenintensiv.

Ferner sind auch Verfahren zum selektiven, bereichsweise Beschichten bekannt, bei denen ganz auf eine Abdeckfolie verzichtet wird. Jedoch müssen dort anstelle des Aufbringens einer Abdeckfolie, z.B. in einem Siebdruckverfahren, andere Verfahren verwendet werden, um sicherzustellen, daß ein gewünschter Aufdruck durch das selektive, bereichsweise Beschichten erhalten wird.

So ist in der DE-PS 41 35 872 bspw. ein Verfahren offenbart, bei dem die Trägerplatte in den nicht zu beschichtenden Bereichen materialabhebend behandelt wird, so daß dort die Wirkschicht, die anschließend aufgebracht wird, nicht anhaftet und somit von der Trägerplatte abziehbar ist.

Während z. B. in der DE-OS 43 33 546 ein Verfahren beschrieben ist, in dem die Wirkschicht durch die Bestrahlung mit Laserlicht entweder bereichsweise mit der Trägerplatte verbunden oder von derselben entfernt wird.

Aus der US-A-5,436,027 ist ein Verfahren zum Aufbringen einer Beschichtung, insbesondere auf einen Flugzeugkörper, bekannt, bei dem zuerst eine Maskenschicht aufgebracht wird, in die mittels eines Laserstrahls die Kontur von zu beschichtenden Bereichen eingeschnitten wird, woraufhin dann in den zu beschichtenden Bereichen die Maskenschicht entfernt und eine Farbschicht über der Maskenschicht flächig aufgebracht wird, so daß abschließend die Maskenschicht mit der darauf befindlichen Farbe entfernt werden kann.

Aus der GB-A-2 158 368 ist ein Verfahren zum teilweise Beschichten eines Gegenstands, insbesondere einer Stoßstange, bekannt, bei dem zuerst eine abziehbare Farbe aufgebracht wird, in die mittels eines Laserstrahls die Kontur eines zu beschichtenden Bereichs ohne Beschädigung eventueller Beschichtungen des Gegenstands geschnitten wird, die Farbe in dem zu beschichtenden Bereich entfernt wird, eine weitere Farbschicht aufgebracht und abschließend der abziehbare Farbfilm mit der darauf aufgebrachten Farbe entfernt wird.

Das Aufbringen einer Masken(farb)schicht ist aufgrund der großen Anzahl der geforderten Arbeitsschritte und des zusätzlichen Materials kosten- sowie arbeitsaufwendig.

Es ist die Aufgabe der Erfindung das gattungsgemäße Verfahren derart weiterzuentwickeln, daß das selektive, bereichsweise Beschichten arbeits- sowie kostensparend und dennoch exakt durchführbar ist, wobei insbesondere auf ein Siebdruckverfahren verzichtet wird.

Diese Aufgabe wird erfindungsgemäß dadurch gelöst, daß eine auf der Trägerplatte flächig aufgeklebte Schutzfolie aus Kunststoff als die die Abdeckfolie bildende Folie verwendet wird, indem die Schutzfolie längs der Kontur der zu beschichtenden Bereiche durchtrennt wird und dann die Teile der Schutzfolie von der Trägerplatte entfernt werden, die die zu beschichtenden Bereiche der Trägerplatte abdecken.

Ferner sieht die Erfindung vor, daß besagte Kontur in eine Recheneinheit eingescannt oder eingegeben wird.

Dabei wird vorgeschlagen, daß das Durchtrennen der die Abdeckfolie bildenden Folie von der Recheneinheit gesteuert wird.

Eine bevorzugte Ausführungsform der Erfindung ist dadurch gekennzeichnet, daß besagte Folie mit einem Schneidplotter längs besagter Kontur durchgeschnitten wird.

Statt dessen kann auch vorgesehen sein, daß besagte Folie durch Laserbestrahlung längs besagter Kontur durchgeschnitten wird.

Eine weiter Alternative ist dadurch gekennzeichnet, daß besagte Folie mit einer Messerklinge längs besagter Kontur durchgeschnitten wird.

Gemäß der Erfindung ist bevorzugt, daß die Teile besagter Folie, die zu beschichtende Bereiche der Trägerplatte abdecken, von der Trägerplatte zum Bilden der Abdeckfolie abgezogen werden.

Bei der Alternative, gemäß der ein Laser eingesetzt wird, schlägt die Erfindung vor, daß die Teile besagter Folie, die zu beschichtende Bereiche der Trägerplatte abdecken, von der Trägerplatte zum Bilden der Abdeckfolie weggeschmolzen werden.

Auch kann alternativerweise vorgesehen sein, daß die Teile besagter Folie, die zu beschichtende Bereiche der Trägerplatte abdecken und von besagter Kontur umschlossen werden, von der Trägerplatte zum Bilden der Abdeckfolie weggeschliffen werden.

Ferner schlägt die Erfindung vor, daß die Wirkschicht im Rollenprägeverfahren aufgebracht wird.

Auch ist erfindungsgemäß als Alternative vorgeschlagen, daß die Wirkschicht aufgedampft wird.

Außerdem kann alternativerweise vorgesehen sein, daß die Wirkschicht aufgeklebt wird.

Der Erfindung liegt die überraschende Erkenntnis zugrunde, daß eine Abdeckfolie nicht z.B. im Siebdruckverfahren auf eine transparente Trägerplatte aufgebracht wird, sondern als Abdeckfolie eine Folie, die vorzugsweise aus Kunststoff besteht, anfänglich auf die Trägerplatte aufgeklebt und danach mittels eines Schneidplotters oder dergleichen "zugeschnitten" wird, so daß die Folie entlang der Kontur derjenigen Bereiche, in denen eine Abdeckfolie gewünscht ist, eingeschnitten ist, und die unerwünschten Teile der Folie bspw. abgezogen worden sind, verwendet wird.

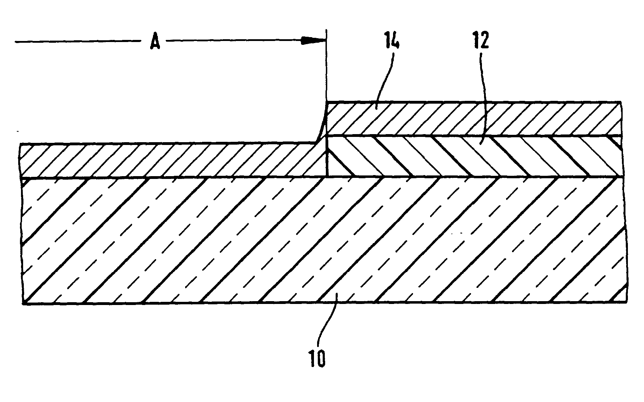

weitere Merkmale und Vorteile der Erfindung ergeben sich aus der nachstehenden Beschreibung, in der ein Ausführungsbeispiel gemäß der Erfindung anhand der aus einer einzigen Figur bestehenden schematischen Zeichnung, die eine erfindungsgemäß beschichtete Trägerplatte vor dem Abziehen der Abdeckfolie in einer Teilansicht im Querschnitt zeigt, erläutert wird.

Dabei zeigt die Figur im einzelnen eine Trägerplatte 10, eine Abdeckfolie 12 und eine Wirkschicht 14, wobei ferner ein Bereich A markiert ist, in dem eine Beschichtung, die die Wirkschicht 14 umfaßt, der Trägerplatte 10 gewünscht und somit keine Abdeckfolie 12 vorhanden ist, während im übrigen Bereich keine Beschichtung mit der Wirkschicht 14 gewünscht und somit eine zwischengeschaltete Abdeckfolie 12 vorhanden ist.

Das selektive, bereichsweise Beschichten der Trägerplatte 10, die z.B. aus klarem Acrylglas besteht, erfolgt gemäß einem Ausführungsbeispiel der Erfindung wie nachstehend beschrieben:

Zuerst wird auf die Trägerplatte 10 eine Kunststoffolie 12 aufgeklebt, wenn die Trägerplatte 10 nicht schon mit einer aufgeklebten Kunststoff-Schutzfolie 12 versehen ist, so daß die Trägerplatte 10 auf jeden Fall mit einer Kunststoffolie 12 flächig bedeckt ist.

Dann wird auf die Kunststoffolie 12 entlang der Kontur des gewünschten Aufdrucks, z.B. in Form von Ornamenten und/oder Buchstaben, der bspw. über einen Scanner in einen Schneidplotter eingelesen worden ist, mittels des Schneidplotters eingeschnitten.

Anschließend wird die Kunststoffolie 12 in den Bereichen A, in denen eine Beschichtung erwünscht ist, von der Trägerplatte 10 abgezogen, so daß die auf der Trägerplatte 10 verbleibende Kunststoffolie 12 eine Abdeckfolie bildet.

Sodann wird die Wirkschicht 14, bspw. eine metallische Prägefolienbeschichtung, in einem Rollenprägeverfahren auf die gesamte, die Abdeckfolie 12 tragende Trägerplatte 10 aufgebracht, so daß die in der Figur gezeigte, beschichtet Trägerplatte 10 entsteht.

Schließlich wird die Abdeckfolie 12 samt der auf ihr aufgebrachten Wirkschicht 14 von der Trägerplatte 10 abgezogen, so daß die den gewünschten Aufdruck bildende Beschichtung, die die Wirkschicht 14 umfaßt, nur noch zurückbleibt.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Verfahren zum selektiven, bereichsweisen Beschichten einer transparenten Trägerplatte mit einer Wirkschicht, bei dem zunächst eine Abdeckfolie, die lediglich die nicht zu beschichtenden Bereiche der Trägerplatte abdeckt, auf der Trägerplatte ausgebildet wird, woraufhin die Wirkschicht auf die gesamte die Abdeckfolie tragende Fläche der Trägerplatte aufgebracht und schließlich die Abdeckfolie samt der darauf angeordneten Wirkschicht von der Trägerplatte abgezogen wird, dadurch gekennzeichnet, daß
eine auf der Trägerplatte flächig aufgeklebte Schutzfolie aus Kunststoff als die die Abdeckfolie bildende Folie verwendet wird, indem die Schutzfolie längs der Kontur der zu beschichtenden Bereiche durchtrennt wird und dann die Teile der Schutzfolie von der Trägerplatte entfernt werden, die die zu beschichtenden Bereiche der Trägerplatte abdecken.

2. Verfahren nach Anspruch 1, dadurch gekennzeichnet, daß besagte Kontur in eine Recheneinheit eingescannt oder eingegeben wird.

3. Verfahren nach Anspruch 2, dadurch gekennzeichnet, daß das Durchtrennen der die Abdeckfolie bildenden Folie von der Recheneinheit gesteuert wird.

4. Verfahren nach einem der vorangegangenen Ansprüche, dadurch gekennzeichnet, daß besagte Folie mit einem Schneidplotter längs besagter Kontur durchgeschnitten wird.

5. Verfahren nach einem der vorangegangenen Ansprüche, dadurch gekennzeichnet, daß besagte Folie durch Laserbestrahlung längs besagter Kontur durchgeschnitten wird.

6. Verfahren nach einem der vorangegangenen Ansprüche, dadurch gekennzeichnet, daß besagte Folie mit einer Messerklinge längs besagter Kontur durchgeschnitten wird.

7. Verfahren nach einem der vorangegangenen Ansprüche, dadurch gekennzeichnet, daß die Teile besagter Folie, die zu beschichtende Bereiche der Trägerplatte abdecken, von der Trägerplatte zum Bilden der Abdeckfolie abgezogen werden.

8. Verfahren nach Anspruch 5, dadurch gekennzeichnet, daß die Teile besagter Folie, die zu beschichtende Bereich der Trägerplatte abdecken, von der Trägerplatte zum Bilden der Abdeckfolie weggeschmolzen werden.

9. Verfahren nach einem der Ansprüche 1 bis 3, dadurch gekennzeichnet, daß die Teile besagter Folie, die zu beschichtende Bereiche der Trägerplatte abdecken und von besagter Kontur umschlossen werden, von der Trägerplatte zum Bilden der Abdeckfolie weggeschliffen werden.

10. Verfahren nach einem der vorangegangenen Ansprüche, dadurch gekennzeichnet, daß die Wirkschicht im Rollenprägeverfahren aufgebracht wird.

11. Verfahren nach einem der Ansprüche 1 bis 9, dadurch gekennzeichnet, daß die Wirkschicht aufgedampft wird.

12. Verfahren nach einem der Ansprüche 1 bis 9, dadurch gekennzeichnet, daß die Wirkschicht aufgeklebt wird.

## Claims

1. A method of selectively coating zones of a transparent carrier plate with an active coating, wherein a cover film, which covers only those zones of the carrier plate which are not to be coated, is first formed on the carrier plate, whereupon the active coating is applied to the entire surface of the carrier plate carrying the cover film, and finally the cover film together with the active coating disposed thereon is removed from the carrier plate, characterised in that a protective film of plastic stuck flat on the carrier plate is used as the film forming the cover film, the protective film being separated along the contour of the zones that are to be coated and then those parts of the protective film which cover the carrier plate zones for coating are removed from the carrier plate.

2. A method according to claim 1, characterised in that the said contour is scanned or input into a computer unit.

3. A method according to claim 2, characterised in that the separation of the film forming the cover film is controlled by the computer unit.

4. A method according to any one of the preceding claims, characterised in that the said film is cut through along the said contour with a cutting plotter.

5. A method according to any one of the prededing claims, characterised in that the said film is cut through along the said contour by laser irradiation.

6. A method according to any one of the preceding claims, characterised in that the said film is cut through along the said contour with a knife blade.

7. A method according to any one of the preceding claims, characterised in that the parts of the said film which cover those carrier plate zones which are to be coated are removed from the carrier plate to form the cover film.

8. A method according to claim 5, characterised in that the parts of the said film which cover those carrier plate zones which are to be coated are melted away from the carrier plate to form the cover film.

9. A method according to any one of claims 1 to 3, characterised in that the parts of the said film which cover those carrier plate zones which are to be coated and are enclosed by the said contour are ground away from the carrier plate to form the cover film.

10. A method according to any one of the preceding claims, characterised in that the active coating is applied by the roller embossing method.

11. A method according to any one of claims 1 to 9, characterised in that the active coating is applied by vapour-coating,

12. A method according to any one of claims 1 to 9, characterised in that the active coating is applied by sticking.

## Revendications

1. Procédé de revêtement sélectif par zones d'une plaque-support transparente avec une couche active, pour lequel on réalise d'abord sur la plaque-support une feuille de couverture, qui recouvre uniquement les zones, n'étant pas à revêtir, de la plaque-support, suite à quoi on applique la couche active sur l'ensemble de la surface de plaque-support portant la feuille de couverture et, enfin, on extrait de la plaque-support la feuille de couverture avec la couche active disposée dessus, caractérisé en ce qu'une feuille protectrice, appliquée par collage sur toute la surface de la plaque-support, constituée d'une matière synthétique, est utilisée comme feuille formant la feuille de couverture, par le fait que la feuille protectrice est séparée le long du contour des zones à revêtir et que sont enlevées de la plaque-support les parties de la feuille protectrice qui couvrent les zones à revêtir de la plaque-support.

2. Procédé selon la revendication 1, caractérisé en ce que ledit contour est mémorisé dans une unité de calcul, par exploration au scanneur ou par introduction.

3. Procédé selon la revendication 2, caractérisé en ce que le processus de séparation de la feuille formant la feuille de couverture est commandé par l'unité de calcul.

4. Procédé selon l'une des revendications précédentes, caractérisé en ce que ladite feuille est découpée le long dudit contour, en utilisant un traceur découpeur.

5. Procédé selon l'une des revendications précédentes, caractérisé en ce que ladite feuille est découpée le long dudit contour, par irradiation laser.

6. Procédé selon l'une des revendications précédentes, caractérisé en ce que ladite feuille est découpée le long dudit contour, en utilisant une lame de couteau.

7. Procédé selon l'une des revendications précédentes, caractérisé en ce que les parties de ladite feuille qui couvrent les zones à revêtir de la plaque-support sont extraites de la plaque-support pour former la feuille de couverture.

8. Procédé selon la revendication 5, caractérisé en ce que les parties de ladite feuille qui couvrent la zone à revêtir de la plaque-support sont enlevées de la plaque-support par un processus de fusion, pour former la plaque de couverture.

9. Procédé selon l'une des revendications 1 à 3, caractérisé en ce que les parties de ladite feuille, qui couvrent les zones à revêtir de la plaque-support et sont entourées par ledit contour, sont enlevées de la plaque-support, par un processus d'abrasion, pour former la feuille de couverture.

10. Procédé selon l'une des revendications précédentes, caractérisé en ce que la couche active est appliquée dans un procédé de façonnage tridimensionnel . utilisant des rouleaux.

11. Procédé selon l'une des revendications 1 à 9, caractérisé en ce que la couche active est appliquée par dépôt par métallisation sous vide.

12. Procédé selon l'une des revendications 1 à 9, caractérisé en ce que la couche active est appliquée par collage.
